# EUROPEAN PATENT APPLICATION

(11) **EP 0 762 493 A1**
(43) Date of publication of application: **12.03.1997**
(21) Application number: 96111989.8
(22) Date of filing: 25.07.1996
(51) Int. Cl.: H01L 21/762, H01L 21/8238

(54) **Semiconductor device having field oxide regions and a field implant and method of manufacturing the same**

(30) Priority: 03.08.1995 US 505529
(71) Applicant: MOTOROLA, INC., Schaumburg, IL 60196 (US)
(72) Inventor: Meixner, Tom, Chandler, Arizona 85224 (US); Redd, Randy D., Chandler, Arizona 85225 (US); Axan, Brad, Chandler, Arizona 85226 (US)
(74) Representative: Hudson, Peter David

(57) **Abstract**

A method of forming field oxide regions and a self-aligned field implant is disclosed where the field implant (130) is performed after the field oxide regions (38,39,40) are formed. An alternate masking layer (60,60') is used during the field implant to form a combined doped layer (62,62') in at least a portion of an active area (41) of a semiconductor device. The combined doped layer is self-aligned to the field oxide regions (38,39).

## Description

### Background of the Invention

The present invention relates in general to processing metal oxide semiconductor (MOS) integrated circuits and, more particularly to device isolation in MOS integrated circuits.

In MOS integrated circuits, it is desirable to isolate active devices from each other to insure proper circuit function. Typically, device isolation is achieved using one of a variety of methods derived from the original Localized Oxidation Of Silicon (LOCOS) introduced by Appels and Kooi (J.A. Appels et al., *Phillips Research Reports*, 25, 118 (1970)). A summary of the principle methods can be found in sections 2.2 through 2.5 of S. Wolf, *Silicon Processing for the VLSI ERA* - *Volume II*, *Pages 17-39*, Lattice Press, Sunset Beach, CA (1990) which is hereby incorporated by reference.

A key component of most of these isolation schemes is a channel-stop implant in regions where the field oxide is grown. In N-channel MOS (NMOS) circuits, a p-type implant of boron is typically used, while in P-channel MOS (PMOS) circuits (or the PMOS side of complimentary MOS (CMOS) circuits) an n-type dopant, such as arsenic is used. Typically, the channel-stop implant is performed prior to field oxide growth by thermal oxidation. The channel-stop region, insures that depletion region spreading from one active device to another is slowed. In addition, the channel-stop region prevents parasitic devices, that can be created by a conductor running over a field oxide region, from turning on. Finally, the channel-stop region helps eliminate surface leakage that could result in high current drain at low voltages.

Despite these advantages, the channel-stop process has inherent problems as well. One such problem is the photolithography or masking steps that must be performed to mask the channel-stop implant(s) from the active device regions and, in complementary structures, from opposing well regions. In CMOS devices requiring both p and n channel-stop regions two masking steps are typically required. Each masking step adds cost and complexity to the fabrication process.

In addition, control of the implant process and formation of the channel-stop region often present problems. As the channel-stop implant is most typically performed prior to field oxidation, one such control problem is providing an implant of sufficient energy and dose to avoid being consumed during the oxidation process. For example, boron doses on the order of 5E12 to 5E13 atoms/cm² and implant energies in the 60,000 to 100,000 electron volts (60 to 100 keV) range are typical. However, care must be exercised to insure that the boron concentration is not so high as to cause an increase in source/drain to substrate capacitances and reduced breakdown voltages.

Another problem is dopant spreading, or lateral diffusion. Lateral diffusion of the dopant can result in encroachment on the active areas. Encroachment can result in channel-stop dopant surface concentration in the channel region near the edge of the field oxide becoming too high, causing the threshold voltage (Vt) in that region to increase. Thus the conductivity of the channel along its width will vary as a function of distance from the field oxide. This can be especially critical as device geometry's shrink, as it can result in device Vt variations based upon device size, rather than design considerations.

Problems associated with the oxidation process can be eliminated by performing the channel-stop implant after the oxidation step. However, this requires difficult, high energy implants on the order of 400 keV for a 0.8 micrometer (µm) oxide layer. At such high energy levels the materials used to mask the active areas can seriously degrade thus requiring special processing for their removal.

Thus there exists the need for a method of providing a channel-stop implant effect without the extra masking steps commonly used when an actual channel-stop implant is performed. In addition, there exists the need for a method of providing the effect of a channel-stop implant that is free of dopant redistribution and segregation effects caused by the field oxidation process. Finally, there exists the need for a method of fabricating small geometry devices with consistent threshold voltages based upon design considerations.

### Brief Description of the Drawings

FIG. 1 is a cross-sectional representation of a portion of a semiconductor wafer at a process step common to both the prior art and an embodiment of the present invention;
FIGs. 2-4 are cross-sectional representations of a portion of a semiconductor wafer that show the process steps of the prior art, requiring a channel-stop implant;
FIGs. 5-6 are cross-sectional representations of a portion of a semiconductor wafer that show the process steps of an embodiment of the subject invention;
FIG. 7 is a cross-sectional representation of a portion of a semiconductor wafer showing an alternate embodiment of the subject application; and
FIG. 8 is a graph of current versus voltage comparing threshold voltages of a field transistor of an embodiment of the present invention against a typical prior art device.

### Detailed Description of the Drawings

The method of the present invention is applicable to a wide variety of semiconductor fabrication processes. For ease of understanding, a CMOS process utilizing a poly buffered LOCOS (PBL) process has been selected to illustrate the steps of an embodiment of the present invention. It will be realized that the PBL process is but one of many LOCOS derivative processes that could have been selected and is used for illustration only. It will also be realized that although not shown, the method described herein is applicable to NMOS, PMOS or BiCMOS device processing. Further, it will be realized that a plurality of first well regions of a first conductivity and a plurality of second well regions of a second conductivity could have been illustrated, however for ease of illustration and understanding a single well of each conductivity is described. It should also be appreciated that current device fabrication processes often employ an epitaxial layer overlying the substrate, and that the subject invention is also applicable to a structure including an epitaxial layer.

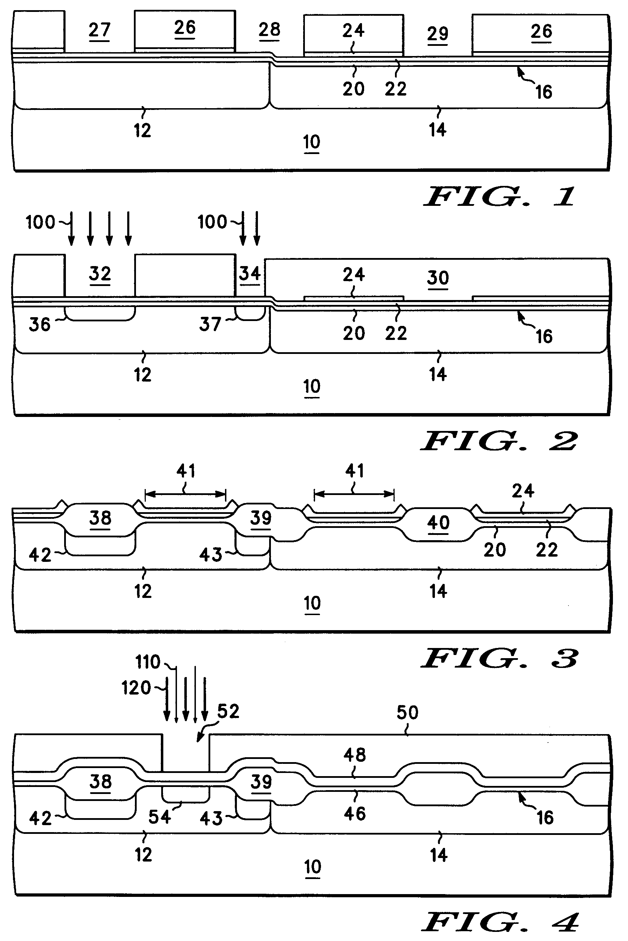

Shown in FIG. 1 is a portion of a CMOS semiconductor device during the initial stages of fabrication. Semiconductor substrate 10 is a substrate which has a major surface 16 and p-well 12 and n-well 14 formed therein. Substrate 10 will be of a first conductivity, for example p-type, and have a first concentration resulting in a resistivity specifically tailored for the device types being fabricated. For example the structure depicted in FIG. 1 would typically have a resistivity in the range of approximately 14 to 22 ohms-centimeter. It will be appreciated that in the described embodiment p-well 12 is a region of a first conductivity and n-well 14 is a region of a second conductivity with dopant concentrations different than that of substrate 10. For example in substrate 10, p-well 12 will be a region of a second concentration, typically doped with boron at a dose of 6 to 9E12 atoms/cm² and an energy of 25 to 50 keV. Again referring to substrate 10, n-well 14 will be a region typically doped with phosphorus at a dose of 6 to 9E12 atoms/cm² and an energy of 80 to 150 keV. Any one of several techniques, well known to those of ordinary skill in the art, could be employed to form p-well 12 and n-well 14 with these dopant materials and concentrations. For example, various forms of masked diffusion utilizing solid or gaseous dopant sources, or ion implantation processes have successfully been employed.

It will also be understood, that semiconductor substrate 10 can be understood to comprise an epitaxial silicon layer overlying a semiconductor wafer with well regions formed within the epitaxial layer. In addition, it will be understood that the twin well structure shown in FIG. 1 is not the only CMOS structure possible, but is rather used as a convenient tool for illustrative purposes. For example, in a p-type substrate 10, the formation of a single region of a second conductivity type, for example n-well 14, will allow the subsequent formation of CMOS transistors. Alternatively, substrate 10 can be a n-type substrate with only a single p-well 12 formed therein. Thus it is understood, that the method of the present invention can be implemented with equal ease and benefit for any combination of substrates, with or without epitaxial silicon layers, and wells.

Referring again to FIG. 1, oxide layer 20 and polysilicon layer 22 are shown overlying major surface 16. Silicon nitride layer 24 and masking layer 26 have been formed overlying polysilicon layer 22, and are depicted after a patterning step where field openings 27, 28 and 29 have been formed. It is well understood that the combination of oxide, polysilicon and nitride layers as illustrated in FIG. 1 is a typical precursor to a PBL structure. The formation of each layer shown overlying major surface 16, and the patterning of layers 24 and 26 to form field openings 27, 28 and 29 are accomplished by methods well known in the semiconductor processing arts.

Turning now to FIG. 2, the prior art process is shown after masking layer 26 has been removed and a second masking layer 30 has been formed and patterned to form channel-stop openings 32 and 34, and to completely mask n-well 14. It is seen that channel-stop opening 32 corresponds approximately to the location of field opening 27, as depicted in FIG. 1, and channel-stop opening 34 corresponds approximately to that portion of field opening 28, from FIG. 1, that is within p-well 12. Channel-stop regions 36 and 37 are formed by channel-stop implant 100 in openings 32 and 34 respectively. Typically, relatively high doses of boron, 5E12 to 5E13 atoms/cm², at implant energies of 60 to 100 keV are employed to form channel-stop regions 36 and 37. As mentioned in the background, such high boron doses, common in the prior art, can result in reduced breakdown voltages and increased source/drain capacitances as well as variations in active device thresholds due to excessive lateral diffusion with acceptable field threshold voltages. While not shown, additional masking and ion implantation processes can be used to form channel-stop regions in n-well region 14.

FIG. 3, illustrates the prior art process after second masking layer 30 has been removed and field oxide regions 38, 39 and 40 are formed. A high temperature thermal oxidation process is used to both form oxide regions 38, 39 and 40, and redistribute the dopant of channel-stop regions 36 and 37, depicted in FIG. 2, to result in redistributed channel-stop regions 42 and 43. The formation of oxide regions 38, 39 and 40 define outer boundaries of active areas within p-well 12 and n-well 14, for example active area 41 is formed in between oxide regions 38 and 39.

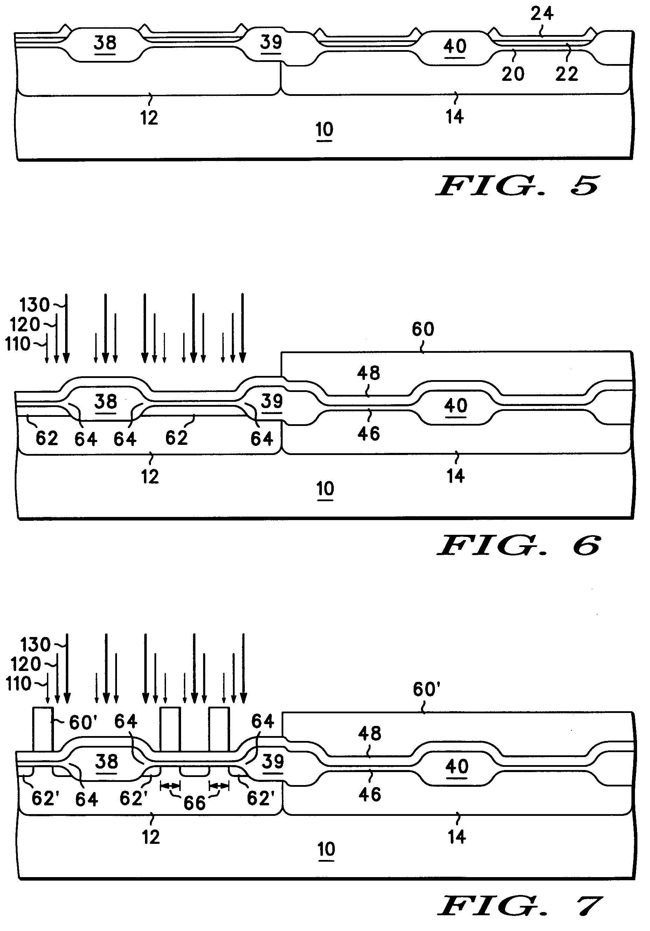

In prior art FIG. 4, remaining oxide layer 20, polysilicon layer 22 and nitride layer 24, depicted in FIG. 3, have been removed. Gate oxide layer 46 has been formed overlying major surface 16 and gate polysilicon layer 48 formed overlying gate oxide layer 46. Third masking layer 50 has been deposited and patterned to create device channel opening 52 between field oxide regions 38 and 39 in p-well 12. Third masking layer 50 serves as an implant mask for substrate 10 during threshold adjust (Vt) implant 110 and punchthru implant 120 which form doped device channel region 54. In an NMOS device, Vt implant 110 is typically boron with a dose of between approximately 1E11 and 1E12 atoms/cm² and an implant energy of between approximately 10 to 40 keV. Punchthru implant 120 is typically between approximately 5E12 to 5E13 atoms/cm² at an implant energy of between approximately 80 to 150 keV. Thus Vt implant 110 places its maximum dopant concentration at a first depth close to the surface of p-well 12. Punchthru implant 120, however, results in a peak dopant concentration at a second depth below that of Vt implant 110 and wherein the second depth is consistent with that of source/drain regions (not shown) that will be formed in subsequent process steps.

Turning now to FIG. 5, a cross-sectional representation of a step in the method of the subject invention is shown. In FIG. 5, a structure similar to FIG. 1 is shown after masking layer 26, of FIG. 1, has been removed and a field oxidation process completed. Contrary to the prior art structure of FIG. 3, the structure of FIG. 5 is without redistributed channel-stop regions 42 and 43 depicted in FIG. 3. Thus the method of the present invention does not require the formation and patterning of second masking layer 30 and or channel-stop implant 100 to form channel-stop regions as shown in FIG. 2. In addition, no redistribution of such channel-stop regions occurs during oxidation to form field oxide regions 38, 39 and 40. It is then understood, that the disadvantages of channel-stop regions, as previously mentioned, are avoided.

In FIG. 6, an embodiment of the present invention is illustrated. Remaining oxide layer 20, polysilicon layer 22 and nitride layer 24, as depicted in FIG. 5, have been removed. Gate oxide layer 46 has been grown overlying major surface 16 and gate polysilicon layer 48 formed overlying gate oxide layer 46. However, unlike the prior art, a first alternate masking layer 60 is deposited and patterned to mask only n-well region 14. Three implant processes are used to create combined field implant region or combined doped region 62. Vt implant 110 and punchthru implant 120 are performed in a manner essentially the same as the prior art process, depicted in FIG. 4, and in addition, field implant 130 is further performed. Field implant 130 provides a maximum dopant concentration below that of punchthru implant 120. For the NMOS example shown, a boron dose in the range of approximately 1E12 to 1E13 atoms/cm² and an energy in the range of approximately 150 to 200 keV can be employed. As depicted, combined doped region 62 extends for some distance under field oxide regions 38 and 39, specifically under a portion of bird's beak areas 64. As one skilled in the art will be aware, the thickness of field oxide regions 38 and 39 vary in the bird's beak areas 64 of each region 38 and 39. Thus the implant masking effect will vary with that variation in thickness. The thicker the oxide, the greater the masking effect. Thus it is seen that where bird's beak areas 64 reach the full thickness of field oxide regions 38 and 39, field implant 130 is essentially completely masked. It should also be apparent that Vt implant 110 and punchthru implant 120 will also be masked by field oxide regions 38 and 39, and as these implants are at a lower energy, less dopant penetration will occur that for field implant 130 in bird's beak areas 64. Finally, it is understood that field implant 130 is self-aligned with respect to an edge of oxide regions 38 and 39, thus forming a self-aligned field implant structure wherein combined doped region 62 is formed only in those areas of p-well 12 not masked by field oxide regions 38 and 39.

It should also be appreciated that it is possible to combine punchthru implant 120 and field implant 130 into one field/punchthru implant (not shown). Such a combination reduces the number of process steps required in the fabrication process at the expense of fine tuning the dopant profile of combined doped region 62. As one skilled in the art will realize, such a combination is a trade off of device performance versus fabrication cost and simplicity. Thus the use of individual implants or a combined implant must be made on a case by case basis.

Turning to FIG. 7, an alternative embodiment of the present invention is illustrated. In comparison with the embodiment depicted in FIG. 6, it is seen that alternative making layer 60' is additionally patterned to mask source and drain regions 66 in active areas of p-well 12. Vt implant 110, punchthru implant 120 and field implant 130 are all performed as described with respect to the embodiment of FIG. 6. However, regions 66 are masked during all implant processes resulting in the formation of a laterally segmented, combined doped region 62'. Such lateral segmentation does not, however, effect the relative distribution of dopant within combined doped regions 62' and the relative positions of the maximum dopant concentration for each implant process is consistent with that previously described. Additionally, combined doped regions 62' are self-aligned with respect to field oxide regions 38 and 39, and extend under bird's beak areas 64, to a degree consistent with the thickness of field oxide in bird's beak areas 64, as previously described. As for the embodiment of FIG. 6, a combined punchthru/field implant 140 (not shown) can be used in lieu of separate punchthru 120 and field implants 130 for the embodiment of FIG. 7.

The isolation effect of the prior art channel-stop implant is a result of the channel-stop regions 42 and 43 (see FIG. 4) being under field oxide regions 38 and 39 respectively. It will be appreciated that the embodiments of the present invention achieve this same result by providing at least a portion of combined doped region 62 or 62' under bird's beak region 64 of field oxide regions 38 and 39 (see FIGs. 6 and 7). Thus, a boundary around and below a portion of each field oxide region 38 and 39 is formed that provides a channel-stop effect. That is, depletion region spreading is slowed, parasitic devices are prevented from turning on and surface leakage currents are reduced.

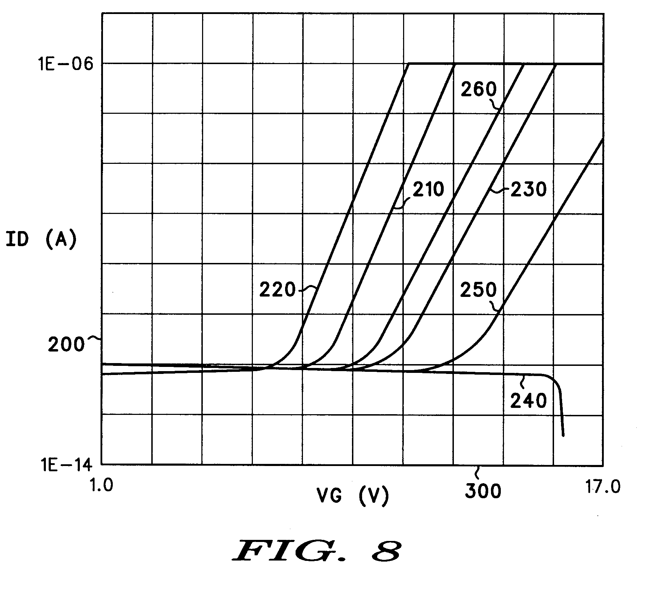

FIG. 8 is a graph of current as measured for a parasitic field transistor measured at various gate biases. Sample devices fabricated utilizing the embodiment of FIG. 6 were compared to a prior art device fabricated with a channel-stop implant process. Y-axis 200 is expressed as micro Amperes (µA) and x-axis 300 as volts. In practice, the data was generated by increasing the voltage while measuring current drain. The voltage required to generate 1.0 µA was recorded for each test device, and appears in Table 1, below. In addition, Table 1 identifies each line in the graph by the implant dose and energy with line 260 representing the prior art process.

**Table 1**

| Line Number | Field Implant Dose (atoms/cm²) | Field Implant Energy (keV) | Voltage Required for 1µA |
|---|---|---|---|
| 210 | 1E12 | 150 | 12.3 |
| 220 | 1E12 | 190 | 10.9 |
| 230 | 2E12 | 170 | 15.5 |
| 240 | 4E12 | 150 | >16 |
| 250 | 4E12 | 190 | >17 |
| 260 | 5E12 | 100 | 14.4 |

A comparison of line 260, representing a prior art process, with each variation in dose and energy of an embodiment of the present invention, clearly illustrate that the embodiment of FIG. 6, is capable of producing dopant concentrations similar to that of the prior art process. In fact, line 260 is seen to be fully within the range of the various test samples. Thus, the results of the prior art process can be achieved and the benefit of fewer masks and process steps inherent in an embodiment of the present invention is realized. Thus the flexible nature of this embodiment in tailoring a desired threshold voltage while retaining the shape of the prior art current and voltage characteristics is clearly seen.

By now it should be appreciated that there has been provided a novel method of making a self-aligning field implant region. The self-aligned field regions fabricated in accordance with the embodiments of the present invention complete the isolation structures required by high performance devices, thereby providing a channel-stop implant effect without the disadvantages of the prior art methods. Thus it has been shown that a non channel-stop isolated semiconductor device with an isolating field region may be fabricated with fewer masking steps than the prior art channel-stop process. In addition it has been shown that the problems of redistribution and segregation of channel-stop dopant during field oxidation have also been eliminated. It has also been shown that device isolation can be completed with tight control of dopant location, greatly enhancing the ability to fabricate devices of consistent performance due to consistent Vt's. Finally it has been shown that the Vt performance of parasitic filed transistors fabricated with an embodiment of the present invention are capable of device performance equal to or in excess of those fabricated with a prior art channel-stop process. Thus a method for simplifying the manufacturing process and providing for lower costs that are associated with higher yields has been provided.

## Claims

1. A method of fabricating a semiconductor device with a self-aligned field implant (130) comprising the steps of:
providing a semiconductor substrate (10);
forming a plurality of first well regions (12) of a first conductivity within said semiconductor substrate (10);
thermally forming oxide regions (38, 39) wherein said oxide regions define at least one active area within at least one well region of said plurality of well regions (12); and
forming at least one doped region (62) of said first conductivity within said at least one active area, wherein said at least one doped region (62) is self-aligned to said oxide regions (38, 39) to provide a channel-stop implant effect.

2. The method of fabricating a semiconductor device with a self-aligned field implant (130) of claim 1, wherein the step of forming at least one doped region (62) further comprises forming said at least one doped region (62) adjacent to an edge of said oxide regions (38, 39).

3. The method of fabricating a semiconductor device with a self-aligned field implant (130) of claim 1, wherein the step of forming said at least one doped region (62) of the first conductivity further comprises the steps of:
implanting (110) a dopant at a first energy and a first dose; and
implanting (120) said dopant at a second energy and a second dose, wherein the second energy is higher than the first energy and the second dose is higher than the first dose.

4. The method of fabricating a semiconductor device with a self-aligned field implant (130) of claim 3, wherein the step of forming at least one doped region (62) of the first conductivity further comprises forming said at least one doped region (62) using a single masking layer.

5. The method of fabricating a semiconductor device with a self-aligned field implant (130) of claim 1, wherein the step of forming at least one doped region (62) of the first conducitivity further comprises forming a laterally segmented doped region (62').

6. The method of fabricating a semiconductor device with a self-aligned field implant (130) of claim 1, further comprising the step of forming a plurality of second well regions (14) of a second conductivity within said semiconductor substrate (10).

7. The method of fabricating a semiconductor device with a self-aligned field implant (130) of claim 6 wherein the step of thermally forming oxide regions (38, 39) further comprises forming oxide regions (39, 40) within said plurality of second well regions (14).

8. A semiconductor device with a field implant (130) comprising:
a semiconductor substrate (10);
a plurality of oxide regions (38, 39, 40), having bird's beak areas (64), in said semiconductor substrate (10), wherein said plurality of oxide regions (38, 39, 40) are formed by thermal oxidation;
at least one active area, wherein said at least one active area is defined by at least one of said plurality of oxide regions (38, 39, 40); and
at least one doped region (62) of a first conductivity or a second conductivity, wherein said at least one doped region (62) is aligned adjacent to said at least one of said plurality of oxide regions (38, 39, 40) and extends from said at least one active area under at least a portion of said bird's beak areas (64) to provide a channel-stop implant effect.

9. An isolated semiconductor device comprising:
a semiconductor substrate (10);
a plurality of first well regions (12) of a first conductivity and a first concentration in said semiconductor substrate (10);
a plurality of second well regions (14) of a second conductivity and a first concentration of said second conductivity in said semiconductor substrate (10);
a plurality of oxide regions (38, 39, 40) in said plurality of first well regions (12) and said plurality of second well regions (14), wherein said plurality of oxide regions (38, 39, 40) are formed by thermal oxidation;
at least one active area in each of said plurality of first well regions (12) and said plurality of second well regions (14), wherein said at least one active area is defined by at least one of said plurality of oxide regions (38, 39, 40); and
at least one doped region (62) of a first conductivity and a second concentration substantially within each said at least one active area in said plurality of first well regions (12), wherein said second concentration is greater than said first concentration and wherein said at least one doped region (62) is adjacent to each of said plurality of oxide regions (38, 39, 40).

10. The isolated semiconductor device of claim 9, further comprising at least one doped region of a second conductivity and a second concentration substantially within said at least one active area in said plurality of second well regions (14), wherein said second concentration is greater than said first concentration and wherein said at least one doped region is adjacent to each of said plurality of oxide regions (38, 39, 40).
